# EUROPÄISCHE PATENTSCHRIFT

(11) **EP 3 252 809 B1**
(45) Veröffentlichungstag und Bekanntmachung des Hinweises auf die Patenterteilung: **11.08.2021**
(21) Anmeldenummer: 17173537.6
(22) Anmeldetag: 30.05.2017
(51) Int. Cl.: H01L 23/04, H01L 23/051, H01L 23/10

(54) **LEISTUNGSMODUL MIT EXPLOSIONSSCHUTZ**
POWER MODULE WITH EXPLOSION PROTECTION
MODULE DE PUISSANCE AVEC PROTECTION CONTRE LES EXPLOSIONS

(30) Priorität: 01.06.2016 DE 102016209577
(43) Veröffentlichungstag der Anmeldung: 06.12.2017
(73) Patentinhaber: Siemens Energy Global GmbH & Co. KG, 81739 München (DE)
(72) Erfinder: Stegmeier, Stefan, 81541 München (DE); Kiefl, Stefan, 80992 München (DE); Mitic, Gerhard, 81827 München (DE); Schmitt, Daniel, 92353 Postbauer-Heng (DE); Schremmer, Frank, 90768 Fürth (DE); Stephan, Jürgen, 82178 Puchheim (DE)

(56) Entgegenhaltungen:
- EP-A1- 3 007 220
- DE-A1- 3 032 133
- JP-A- S5 450 268
- JP-A- H06 177 272
- US-A- 4 249 034
- US-A1- 2008 073 767

## Beschreibung

Die Erfindung betrifft ein Leistungsmodul.

Es ist bekannt, in der Leistungselektronik Schaltmodule in der Art von Leistungsmodulen zu verwenden. Solche Leistungsmodule weisen Leistungshalbleiterbausteine auf, welche regelmäßig einen Emitter und einen Kollektor umfassen, zwischen welchen im thermischen Fehlerfall, insbesondere bei Ausdehnung oder Explosion von Teilen des Leistungsmoduls, ein sicherer dauerhafter Leitungskontakt gewährleistet werden muss. Dieses Erfordernis im Fehlerfall ist als Conductt-on-Fail, d.h. Leitungskontakt im Fehlerfall, geläufig. Beispielsweise ist ein solches Konzept in der Offenlegungsschrift DE 10 2014 207 927 A1 beschrieben. Bei diesem Konzept wird mittels eines Spannverbandes ein Abstandshalter unter Druck gesetzt, welcher einen auf Emitterpotential befindlichen Teil des Leistungsmoduls und einen auf Kollektorpotential befindlichen Teil des Leistungsmoduls voneinander räumlich und im Potential beabstandet. Der Abstandshalter kann im thermischen Fehlerfall erweichen, so dass der auf Emitterpotential befindliche Teil und der auf Kollektorpotential befindliche Teil des Leistungsmoduls mittels Temperatur und Druck miteinander durchlegieren können und somit eine dauerhafte leitende Verbindung eingehen.

Problematisch ist bei solchen Leistungsmodulen jedoch, dass regelmäßig Isolationsmaterialien, insbesondere organische Isolationsmaterialien, eingesetzt werden. Solche Isolationsmaterialien verursachen im Explosionsfall ein hohes Gasvolumen, da Bestandteile des Isolationsmaterials, insbesondere Kohlenstoffketten, Wasserstoffatome, etc., Verbrennungsprodukte wie COx, H2O, etc. bilden. Solche Verbrennungsprodukte dehnen sich auf ein Vielfaches ihres Feststoffvolumens aus, so dass Bestandteile des Leistungsmoduls mitgerissen werden. Folglich besteht eine hohe Gefahr einer Splitterwirkung, die insbesondere auch benachbarte Leistungsmodule beschädigen kann.

Die Druckschrift DE 30 32 133 A1 offenbart eine Halbleitervorrichtung mit einem Halbleiterelement und mit einer Explosionsschutzeinrichtung. Aus der JP 54050268 sind explosionssichere Ringe zum Schutz von Metallelektroden bekannt. In der JP 06177272 ist eine Verstärkung von Metallflanschen von Gleichrichtern beschrieben. Die US20080073767A1 offenbart eine Halbleitervorrichtung mit Hitzepuffer. Aus der US 4249034 ist eine Versiegelung einer Halbleitervorrichtung bekannt.

Es ist die Aufgabe der Erfindung, ein verbessertes Leistungsmodul zu schaffen, welches im Fehlerfall betriebssicherer ausgebildet ist. Insbesondere soll die Gefahr der Beschädigung benachbarter Leistungsmodule reduziert sein.

Diese Aufgabe der Erfindung wird mit einem Leistungsmodul mit den in Anspruch 1 angegebenen Merkmalen gelöst. Bevorzugte Weiterbildungen der Erfindung sind in den zugehörigen Unteransprüchen, der nachfolgenden Beschreibung und der Zeichnung angegeben.

Das erfindungsgemäße Leistungsmodul weist ein Gehäuse mit einem Gehäuseteil und mit einem Gehäusedeckel sowie ein Dichtmittel auf, wobei das Dichtmittel in eine den Gehäuseteil und den Gehäusedeckel miteinander dichtende Dichtposition druckbeaufschlagbar ist. Es versteht sich, dass unter der Formulierung "druckbeaufschlagbares Dichtmittel" ein Dichtmittel zu verstehen ist, welches derart angeordnet ist, dass es bei einer plötzlichen Druckbeaufschlagung in die Dichtposition hinein druckbeaufschlagt wird. Auf diese Weise kann sich zum einen das Dichtmittel im Explosionsfall ausdehnen und somit eine Abdichtung von Gehäuseteil und Gehäusedeckel miteinander gewährleisten. Somit ist wirksam vermieden, dass Explosionsgase aus dem Leistungsmodul nach außen hin entweichen können oder deren Entweichung stark vermindert wird. Ein weiterer Vorteil besteht darin, dass die Druckbeaufschlagung des Dichtmittels in die Dichtposition hinein mit einer Verformung zumindest von Teilen des Dichtmittels einhergehen kann. Folglich absorbiert das Dichtmittel zumindest teilweise kinetische Energie der Explosionsgase, indem diese in Verformungsenergie des Dichtmittels umgewandelt wird. Entsprechend ist eine Explosionswirkung minimiert. Infolge dieser Minimierung der Explosionswirkung sowie infolge der Dichtung des Gehäuses des Leistungsmoduls gegenüber explosiv expandierenden Explosionsgasen ist die Betriebssicherheit des erfindungsgemäßen Leistungsmoduls deutlich verbessert. Insbesondere ist mittels des erfindungsgemäßen Leistungsmoduls wirksam vermieden, dass benachbarte Leistungsmodule im Fehlerfall in Mitleidenschaft gezogen werden.

Bei dem erfindungsgemäßen Leistungsmodul ist das Dichtmittel mittels eines innerhalb von Gehäuseteil und Gehäusedeckel und Dichtmittel gebildeten Volumens auftretenden Überdrucks in die Dichtposition druckbeaufschlagbar. In dieser Weiterbildung der Erfindung ist das Leistungsmodul zweckmäßig gegenüber einem innerhalb des Leistungsmoduls auftretenden Überdruck, insbesondere infolge einer Explosion innerhalb des Gehäuses, zuverlässig gedichtet.

Bei dem erfindungsgemäßen Leistungsmodul weist das Dichtmittel eine mehrfach zusammenhängende Topologie mit mindestens einem Ringumfang mit insbesondere welliger und/oder gefalteter Struktur oder Gestalt auf. Erfindungsgemäß verläuft der Ringumfang des Dichtmittels entlang der umfänglichen Richtung des Ringumfangs wellenförmig oder gefaltet; die Wellen- oder Faltungsform verläuft dabei vorzugsweise entlang der umfänglichen Richtung. Insbesondere wird dabei die Wellenform oder die Faltungsform in derjenigen Ebene beschrieben, entlang welcher sich die umfänglichen Richtungen des Ringumfangs erstrecken. Zweckmäßigerweise ist die mehrfach zusammenhängende Topologie mit mindestens einer ringartigen Struktur gebildet, wobei die ringartige Struktur an einem Umfang des Gehäusedeckels und/oder des Gehäuseteils in der Dichtposition anliegt.

Zweckmäßig ist die ringartige Struktur mit dem Ringumfang gebildet. Mittels der welligen und/oder gefalteten Struktur kann sich der Ringumfang im Explosionsfall leicht dehnen. D.h. in der Dichtposition, also im Explosionsfall, ist diese Welligkeit und/oder die Faltigkeit der welligen und/oder gefalteten Struktur verringert und der Ringumfang vergrößert. Insbesondere weist der Ringumfang eine Struktur mit Einkerbungen und/oder Rillen und/oder Rundungen, vorzugsweise in der Art einer Ziehharmonika, auf.

Alternativ oder zusätzlich weist bei dem Leistungsmodul das Dichtmittel mindestens einen oder mehrere Kolbenringe auf. Zweckmäßig sind diese Kolbenringe zwischen Gehäusedeckel und Gehäuseteil, insbesondere in an Gehäusedeckel und/oder Gehäuseteil eingebrachten Ausnehmungen, angeordnet. Geeigneterweise weisen die Kolbenringe umfänglich Öffnungen und/oder Lücken auf, so dass sich der oder die Kolbenringe nach außen hin aufweiten kann/können. Im Fehlerfall können die Explosionsgase hinter den oder die Kolbenringe entweichen und den oder die Kolbenringe gegen den Gehäuseteil pressen. Infolge der Lücken und/oder Öffnungen sind die Kolbenringe jeweils nicht vollumfänglich geschlossen. Zweckmäßigerweise sind die Öffnungen verschiedener Kolbenringe in umfänglicher Richtung gegeneinander versetzt. Auf diese Weise ist ein Explosionsgasweg erheblich verlängert, so dass sich mittels der Explosionsgase im Fehlerfall ein Druck zur Druckbeaufschlagung des oder der Kolbenringe leichter aufbauen lässt.

Zweckmäßigerweise ist bei dem erfindungsgemäßen Leistungsmodul das Dichtmittel mit mindestens einem Polymer und/oder einem Siloxan und/oder einem Metall und/oder einem Verbundwerkstoff und/oder einer Keramik und/oder Polyethylen und/oder Glas und/oder Glasgewebe gebildet. Zweckmäßig ist im Falle eines Verbundwerkstoffes zumindest eine Komponente des Verbundwerkstoffes mit mindestens einer Keramik und/oder einem Glas und/oder Kohlenstofffasern und/oder Nanopartikeln und/oder Nanotubes und/oder Nanowires und/oder anderen Nanostrukturen gebildet. Ein derart ausgebildetes Dichtmittel kann kinetische Energie leicht aufnehmen. Ferner können mit diesen Materialien Dichtmittel gebildet werden, welche leicht dehnbar sind.

In einer bevorzugten Weiterbildung des erfindungsgemäßen Leistungsmoduls ist bei diesem das Dichtmittel mehrlagig, insbesondere mit in Härte und/oder Duktilität aufeinanderfolgend wechselnden Lagen, gebildet. Solche mehrlagigen Dichtmittel können kinetische Energie besonders gut aufnehmen. Zweckmäßig ist das erfindungsgemäße Leistungsmodul im Übrigen gleich dem Leistungsmodul, welches in DE 10 2014 207 927 A1 beschrieben ist, ausgebildet. Der Offenbarungsgehalt dieser Druckschrift sei ausdrücklich in diese Anmeldung mit einbezogen.

Nachfolgend wird die Erfindung anhand eines in der Zeichnung dargestellten Ausführungsbeispiels näher erläutert. Es zeigen:
- Figur 1: ein erstes Ausführungsbeispiel eines erfindungsgemäßen Leistungsmoduls schematisch im Querschnitt,
- Figur 2: einen Gehäusedeckel des Leistungsmoduls gem. Fig. 1 schematisch in einer Draufsicht sowie
- Figur 3: ein weiteres Beispiel eines Leistungsmoduls, das für das Verständnis der vorliegenden Erfindung nützlich ist, schematisch im Querschnitt.

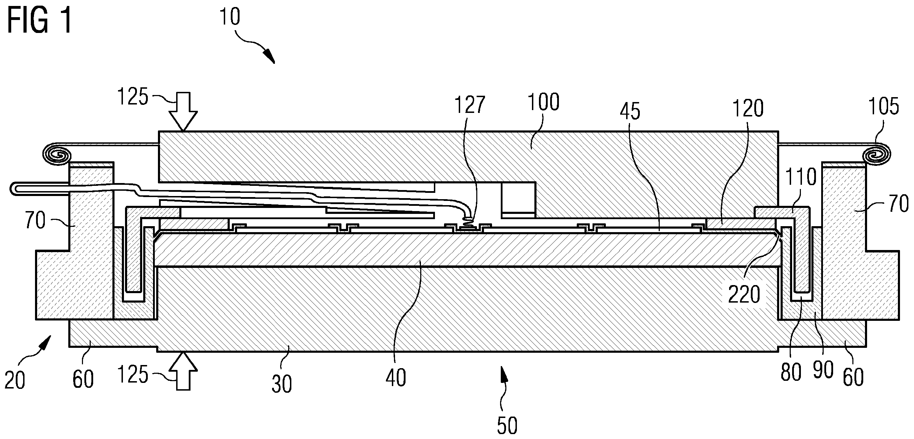

Das in Figur 1 dargestellte erfindungsgemäße Leistungsmodul 10 weist einen ersten Gehäuseteil 20 auf, welcher einen im Wesentlichen sich flächig erstreckenden und kreisrunden Gehäuseboden 30 umfasst. Auf dem Gehäuseboden 30 ist eine sich ebenfalls im Wesentlichen flächig erstreckende kreisrunde Substratplatte 40 mit Halbleiterchips 45 vollflächig aufgebracht. Im Normalbetrieb werden mit Hilfe des Kontakts 127 (Gatezuführungsleitung) über eine planare Verdrahtung (in Fig. 1 nicht explizit gezeigt) die Halbleiterchips 45 angesteuert.

Fern der Substratplatte 40 und nahe an einer äußeren Flachseite 50 des Gehäusebodens 30 ragt an dem Gehäuseboden 30 ein kreisringförmiger Vorsprung 60 radial nach außen aus. Von dem Vorsprung 60 streckt sich eine Gehäusewand 70 aus Keramik in der Art einer Zylindermantelfläche fort, die die Substratplatte 40 umfänglich umgibt und radial von der Substratplatte 40 beabstandet ist. Die Gehäusewand 70, der Gehäuseboden 30, der Vorsprung 60 und die Substratplatte 40 bilden folglich einen kreisringförmig verlaufenden Spalt 80, welcher sich in Richtung von der Bodenplatte 30 fortöffnet.

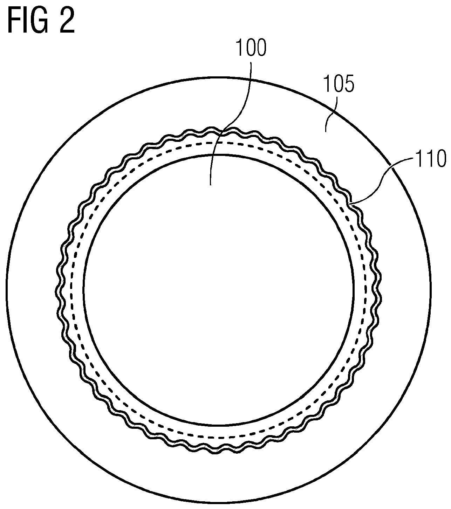

In diesem Spalt 80 ist eine Isolation 90, beispielsweise aus PTFE (Polytetraflourethylen), eingebracht, welche vollumfänglich den Spalt 80 füllt und einen U-förmigen Querschnitt aufweist, der sich ebenfalls in Richtung von der Bodenplatte 30 fortöffnet. Das Leistungsmodul 10 weist zudem einen Gehäusedeckel 100 auf, welcher mit kreisrundem Querschnitt ausgebildet ist. Der Gehäusedeckel 100 (s.a. Fig. 2) weist einen verglichen mit der Substratplatte 40 identischen Querschnitt auf und ist angeordnet, die Substratplatte genau zu bedecken. Dazu weist der Gehäusedeckel 100 einerseits an seiner äußeren Flachseite eine von dieser radial ausragende Bördelung 105 auf, welche zugleich an der Gehäusewand 70 angebunden ist. Grundsätzlich kann der Gehäusedeckel 100 in weiteren, nicht eigens dargestellten Ausführungsbeispielen allerdings auch andere Abmessungen aufweisen.

Weiterhin weist der Gehäusedeckel 100 an seiner inneren Flachseite einen Dichtkragen 110 aus Metall, im dargestellten Ausführungsbeispiel aus Kupfer, auf, welcher an den übrigen Teil des Gehäusedeckels 100 angelötet ist. In weiteren nicht eigens dargestellten Ausführungsbeispielen kann der Dichtkragen 110 auch auf andere Weise an dem übrigen Teil des Gehäusedeckels 100 befestigt sein.

Der Dichtkragen 110 weist einen L-förmigem Querschnitt auf. Ein kürzerer Schenkel des L-förmigen Querschnitts ragt radial aus dem Gehäusedeckel 100 aus, während ein längerer Schenkel des L-förmigen Querschnitts sich senkrecht und parallel zur Gehäusewand 70 vom Gehäusedeckel 100 fortstreckt.

Der längere Schenkel des L-förmigen Querschnitts ragt in den U-förmigen Querschnitt der Isolation 90 in Richtung parallel zur Gehäusewand 70 ein. Der parallel zur Gehäusewand 70 verlaufende Teil des Dichtkragens 110 verläuft entlang der umfänglichen Richtung wellenförmig, d.h. mit entlang der Umfangsrichtung veränderlichem Radius. Somit kann sich der Dichtkragen 110 in radialer Richtung weiten.

Der Gehäusedeckel 100 liegt mit radial außenliegenden Abstandshaltern 120 auf dem Gehäuseboden 30 auf. Ein Spannverband (nicht im Einzelnen, lediglich mittels Pfeilen 125, dargestellt) drückt den Gehäusedeckel 100 auf den Gehäuseboden 30 auf. Die Abstandshalter 120 sind mittels planarer Aufbau- und Verbindungstechnik mit der Emitterseite des Halbleiterchips 45 verbunden.

Um unbeabsichtigten Stromfluss zwischen Substratplatte 40 und Dichtkragen 110 zu vermeiden, ist die Substratplatte 40 im zwischen Halbleiterchips 45 und Isolation 90 liegenden Bereich oberflächlich mit einer Isolierschicht überzogen. Diese Isolierschicht erstreckt sich zudem auch im Bereich zwischen den Abstandshaltern 120 und Substratplatte 40 zur Isolation 90 hin.

Im Fehlerfall entfaltet sich zwischen Gehäusedeckel 100 und Gehäuseboden 30, etwa an den Orten der Halbleiterchips 45, explosionsartig Druck, welcher radial nach außen zum Dichtkragen 110 hin entweicht. Der parallel zur Gehäusewand 70 verlaufende Teil des Dichtkragens 110 weitet sich und kommt mit dem äußeren Schenkel des U-förmigen Querschnitts der Isolation 90 dichtend zur Anlage. Zudem wird ein Teil der Explosionsenergie in Verformungsenergie des Dichtkragens 110 umgesetzt. Eine dichtende Anlage zur Dichtung ist im Explosionsfall völlig ausreichend. Eine feste oder gar stoffschlüssige Verbindung zwischen Gehäusedeckel 100 und Gehäuseboden 30 ist nicht erforderlich. So kann sich im Fehlerfall zudem der Gehäusedeckel 100 etwas vom Gehäuseboden 30 beabstanden, sodass Energie im Spannverband 125 gespeichert wird, welche nachfolgend wieder abgegeben werden kann, indem der Spannverband 125 den Gehäusedeckel 100 auf den Gehäuseboden 30 presst. Die Halbleiterchips 45 können nachfolgend unter Temperatur und Druck durchlegieren und im Fehlerfall elektrisch leitend durchschalten.

In einem weiteren nicht dargestellten Ausführungsbeispiel, welches im Übrigen dem zuvor beschriebenen Ausführungsbeispiel entspricht, besteht der Dichtkragen 110 nicht aus einem Metall, sondern auch aus einem elektrisch isolierenden Material, beispielsweise aus einem hochtemperaturfesten Polymer. In diesem Ausführungsbeispiel ist eine Isolation 90 entbehrlich, da bereits der Dichtkragen 110 elektrisch isoliert. Beispielsweise ist das Polymer des Dichtkragens PTFE (Polytetrafluorethylen).

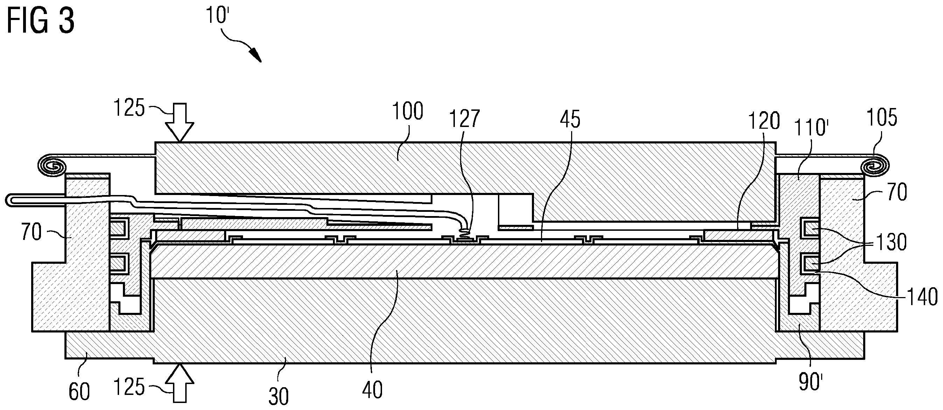

In einem in Figur 3 dargestellten Leistungsmodul 10' ist der Dichtkragen 110' selbst nicht weitbar, sondern als starrer Dichtkragen 110' mit dem Gehäusedeckel 100 verbunden. Die Dichtfunktion wird mittels mehrerer Kolbenringe 130 umgesetzt, welche in außen umfängliche Nuten 140 des parallel zur Gehäusewand 70 verlaufenden Teil des Dichtkragens 110' gelegen sind. Die Isolation 90' ist in diesem Ausführungsbeispiel nicht mit U-förmigem Querschnitt ausgebildet, sondern der radial äußere Schenkel des U-förmigen Querschnitts fehlt, d.h. die Isolation 90' ist mit L-förmigem Querschnitt ausgebildet.

Im Fehlerfall werden die Kolbenringe 130 gegen die Gehäusewand 70 gedrückt. Dabei weisen die Kolbenringe 130 jeweils an einer Umfangsposition eine Öffnung auf, welche sich allerdings für benachbarte Kolbenringe 130 jeweils unterscheiden kann. Auf diese Weise ist der Weg, entlang dessen der Druck entweichen kann, vergrößert.

## Patentansprüche

1. Leistungsmodul mit einem Gehäuse (100, 70, 20) umfassend ein Gehäuseteil (20), einen Gehäusedeckel (100) und zumindest ein Dichtmittel (110; 110'), welches derart angeordnet ist, dass das Dichtmittel bei plötzlich auftretendem Überdruck des durch das Gehäuse (100,70,20) gebildeten Volumens in eine den Gehäuseteil (20) und den Gehäusedeckel (100) miteinander dichtende Dichtposition druckbeaufschlagt wird, wobei das Dichtmittel mindestens einen Ringumfang aufweist, **dadurch gekennzeichnet, dass** der Ringumfang des Dichtmittels in umfänglicher Richtung des Ringumfangs wellig und/oder gefaltet verläuft.

2. Leistungsmodul nach Anspruch 1, bei welchem das Dichtmittel (110) mit mindestens einem Polymer und/oder einem Siloxan und/oder einem Metall und/oder einem Lot und/oder einem Verbundwerkstoff und/oder einer Keramik und/oder Polyethylen und/oder Glas und/oder Glasgewebe gebildet ist.

3. Leistungsmodul nach einem der vorhergehenden Ansprüche, bei welchem das Dichtmittel (110) mehrlagig, insbesondere mit in Härte oder Duktilität aufeinanderfolgend wechselnden Lagen, gebildet ist.

## Claims

1. Power module with a housing (100, 70, 20) comprising a housing part (20), a housing cover (100) and at least one sealing means (110; 110'), which is arranged in such a way that, in the event of a suddenly occurring excess pressure of the volume formed by the housing (100, 70, 20), the sealing means is pressurized into a sealing position which seals the housing part (20) and the housing cover (100) to one another, wherein the sealing means has at least one ring circumference, **characterized in that** the ring circumference of the sealing means runs in a wavy and/or folded manner in the circumferential direction of the ring circumference.

2. Power module according to Claim 1, in which the sealing means (110) is formed with at least a polymer and/or a siloxane and/or a metal and/or a solder and/or a composite material and/or a ceramic and/or polyethylene and/or glass and/or glass fabric.

3. Power module according to either of the preceding claims, in which the sealing means (110) has a multi-layered form, in particular with layers which vary in succession in terms of hardness or ductility.

## Revendications

1. Module de puissance, comprenant un boîtier (100, 70, 20) comprenant une partie (20) de boîtier, un couvercle (100) de boîtier et au moins un moyen (110 ; 110') d'étanchéité, qui est disposé de manière à ce que le moyen d'étanchéité, s'il se produit soudainement une surpression du volume formé par le boîtier (100, 70, 20), soit mis sous pression dans une position d'étanchéité rendant étanches entre eux la partie (20) du boîtier et le couvercle (100) du boîtier, dans lequel le moyen d'étanchéité a au moins un pourtour annulaire,
**caractérisé en ce que**
le pourtour annulaire du moyen d'étanchéité s'étend de manière ondulée et/ou pliée dans la direction périphérique du pourtour annulaire.

2. Module de puissance suivant la revendication 1, dans lequel le moyen (110) d'étanchéité est formé d'au moins un polymère et/ou d'un siloxane et/ou d'un métal et/ou d'une brasure et/ou d'un matériau composite et/ou d'une céramique et/ou de polyéthylène et/ou de verre et/ou de tissu de verre.

3. Module de puissance suivant l'une des revendications précédentes, dans lequel le moyen (110) d'étanchéité est formé en plusieurs couches, en ayant notamment des couches alternant successivement en dureté ou en ductilité.
